(19) **Europäisches Patentamt / European Patent Office / Office européen des brevets**

(11) **EP 2 276 083 B1**

(12) **EUROPEAN PATENT SPECIFICATION**

(45) Date of publication and mention
of the grant of the patent:
**27.02.2013 Bulletin 2013/09**

(51) Int Cl.:
***H01L 45/00*** *(2006.01)*

(21) Application number: **08014827.3**

(22) Date of filing: **21.08.2008**

(54) **Method for fabricating an integrated circuit with line-lithography processes and integrated circuit fabricated with line-lithography processes**

Verfahren zur Herstellung einer integrierten Schaltung mit Linienlithografieverfahren und integrierte Schaltung, die mit Linienlithografieverfahren hergestellt wurde

Procédé de fabrication d'un circuit intégré avec des processus de lithographie en ligne et circuit intégré fabriqué avec les procédés de lithographie en ligne

(84) Designated Contracting States:
**DE FR GB**

(72) Inventors:
• **Happ, Thomas**
  **01109 Dresden (DE)**
• **Philipp, Jan Boris**
  **81673 München (DE)**

(43) Date of publication of application:
**19.01.2011 Bulletin 2011/03**

(73) Proprietor: **Qimonda AG**
**81739 München (DE)**

(56) References cited:
**US-A1- 2007 099 405    US-A1- 2007 187 829**

EP 2 276 083 B1

## Description

### Field of the Invention

The invention relates to a method for fabricating an integrated circuit (IC), in particular to a method for fabricating a memory device including resistance changing material such as a Phase Change Random Access Memory ("PCRAM"). Further, the invention relates to an integrated circuit (IC), in particular to a memory device including resistance changing material such as a Phase Change Random Access Memory ("PCRAM").

### Background of the Invention

One type of memory is resistive memory. Resistive memory utilizes the resistance value of a memory element to store one or more bits of data. For example, a memory element programmed to have a high resistance value may represent a logic "1" data bit value and a memory element programmed to have a low resistance value may represent a logic "0" data bit value. Typically, the resistance value of the memory element is switched electrically by applying a voltage pulse or a current pulse to the memory element.

One type of resistive memory is phase change memory. Phase change memory uses a phase change material in the resistive memory element. The phase change material exhibits at least two different states. The states of the phase change material may be referred to as the amorphous state and the crystalline state, where the amorphous state Involves a more disordered atomic structure and the crystalline state involves a more ordered lattice. The amorphous state usually exhibits higher resistivity than the crystalline state. Also, some phase change materials exhibit multiple crystalline states, e.g. a face-centered cubic (FCC) state and a hexagonal closest packing (HCP) state, which have different resistivities and may be used to store bits of data. In the following description, the amorphous state generally refers to the state having the higher resistivity and the crystalline state generally refers to the state having the lower resistivity.

Phase changes in the phase change materials may be induced reversibly. In this way, the memory may change from the amorphous state to the crystalline state - "set" - and from the crystalline state to the amorphous state - "reset" - in response to temperature changes. Temperature changes may be applied to the phase change material by heat pulses. The temperature changes of the phase change material may be achieved by driving current through the phase change material itself or by driving current through a resistive heater adjacent the phase change material. With both of these methods, controllable heating of the phase change material causes controllable phase change within the phase change material. The mixture of phase change material with insulating material reduces the volume of phase change material which needs to be heated. The insulating material in the mixture is not performing a phase change during cell operation.

A phase change memory including a memory array having a plurality of memory cells that are made of phase change material may be programmed to store data utilizing the memory states of the phase change material. One way to read and write data in such a phase change memory device is to control a current and/or a voltage pulse that is applied to the phase change material. The temperature in the phase change material in each memory cell generally corresponds to the applied level of current and/or voltage to achieve the heating.

To achieve higher density phase change memories, a phase change memory cell can store multiple bits of data. Multi-bit storage in a phase change memory cell can be achieved by programming the phase change material to have intermediate resistance values or states, where the multi-bit or multilevel phase change memory cell can be written to more than two states. If the phase change memory cell is programmed to one of three different resistance levels, 1.5 bits of data per cell can be stored. If the phase change memory cell is programmed to one of four different resistance levels, two bits of data per cell can be stored, and so on. To program a phase change memory cell to an intermediate resistance value, the amount of crystalline material coexisting with amorphous material and hence the cell resistance is controlled via a suitable write strategy.

In Ahn et al., "Highly Reliable 50nm Contact Cell Technology for 256Mb PRAM", 2005 Symposium on VLSI Technology, Digest of Technical Papers pp98-99, a small contact fabrication technology is proposed for high density PCRAMs. A spacer-etch-process is utilized to form a sub-lithographic heater within a conventional through-hole.

Pellizzer et al., "Novel μTrench Phase-Change Memory Cell for Embedded and Stand-Alone Non-Volatile Memory Applications", 2004 Symposium on VLSI Technology, Digest of Technical Papers pp18-19, present a cell structure for chalcogenide-based non-volatile phase change memories. They introduce an architecture for a compact vertical integration.

In Pirovano et al., "Self-Aligned μTrench Phase-Change Memory Cell Architecture for 90nm Technology and Beyond", 37th European Solid State Device Research Conference (ESSDERC), 2007, pp 222-225, a self-aligned patterning strategy is employed for simplified integration process of Phase Change Random Access Memory ("PCRAM") cells.

A further example is found in patent document US 2007/99405.

Below minimum feature sizes of 46nm the conventional lithography for holes will meet the limits. From today's perspective, line-lithography should be able to reproduce and print minimum feature sizes of 46nm. Specifically, self-aligned double patterning techniques used for patterns with a half-pitch less than 40nm rely on line-based structuring. For technology nodes with minimum feature sizes below 46nm there is a need for integration schemes for fabricating integrated circuits (IC), in particular to fabricate a memory device including resistance changing material such as a Phase Change Random Access Memory ("PCRAM").

## Summary of the Invention

It is an object of the invention to provide an integrated circuit including resistance changing material at a minimum feature size below 46nm. This is achieved by the claimed method for fabricating an integrated circuit and by the claimed integrated circuit itself. Further aspects of the invention are described within the dependent claims. The invention can also be applied to minimum feature sizes equal or greater 46nm.

A method for fabricating an integrated circuit includes forming a first electrode, forming a heater element coupled to the first electrode, forming a cavity over the heater element whereby the cavity is laterally surrounded by a first dielectric material and a second dielectric material, depositing resistance changing material into the cavity, and forming a second electrode over the resistance changing material. Forming the heater element includes depositing a third dielectric material over the first electrode, structuring the third dielectric material by means of a line-lithography-process, and depositing the heater material over the third dielectric material. Forming the cavity includes depositing a sacrificial material and structuring the sacrificial material by means of a line-lithography-process.

Line-lithography-process is a lithography process which utilizes the printing of lines. Typically, patterns of parallel lines are printed with line-lithography-processes. In contrast to conventional lithography which may print holes, line-lithography extends the range of minimum feature size below 46nm. The invention can also be applied to minimum feature sizes equal or greater 46nm.

Structuring by means of line-lithography includes depositing a photoresist (PR) over a material, exposing the photoresist with a line pattern, developing the photoresist to remove either exposed or not exposed parts of the photoresist, and structuring the material by using the structured photoresist as a mask.

In one implementation, the heater element is formed by structuring the heater material in a first direction by a spacer-etch-process. A forth dielectric material is deposited over the heater element in another implementation. The cavity is formed by a spacer-etch-process in a further implementation.

In another implementation, forming the cavity further includes depositing a fifth dielectric material over the sacrificial material, structuring the fifth dielectric material by a spacer-etch-process, structuring the heater material in a second direction by using the fifth dielectric material as a mask, and forming the cavity by removing the fifth dielectric material.

Spacer-etch-process is a typical process for semiconductor manufacturing and is widely used, e.g. for gate spacers etc. A structure with side-faces and top-faces is conformally covered by a layer. The layer is etched anisotropically. On planar surfaces - like the top-face - the layer is removed; only on the side-faces of the structure parts of the layer are remaining. The remaining parts of the layer covering the side-faces of the structure are called "spacers".

The method further includes structuring the resistance changing material by using damascene patterning in the cavity in another implementation.

Damascene patterning includes forming structures in a support structure, filling and overfilling these structures with a second material, and removing parts of the second material. The removing of parts of the second material can be by chemical mechanical planarization (CMP).

In one implementation, the resistance changing material includes phase change materials like $Ge_2Sb_2Te_5$ (GST). The resistance changing material is deposited in another implementation into the cavity by at least one of the group of physical vapor deposition (PVD)-process, chemical vapor deposition (CVD)-process, atomic layer deposition (ALD)-process, or solution based spin-on processes.

An integrated circuit includes a first electrode, a heater element coupled to the first electrode, a cavity laterally surrounded by a first dielectric material and a second dielectric material, the cavity is filled with resistance changing material and is coupled to the heater element, and a second electrode coupled to the resistance changing material. The heater element is formed by means of a line-lithography-process and the cavity is formed by means of at least one line-lithography process. And the heater element is L-shaped with an larger contact area towards the first electrode compared to the contact area towards the cavity.

In one implementation, the heater element is a spacer formed by a spacer-etch-process. A dielectric material is deposited over the heater element in another implementation. The cavity is formed by a spacer-etch-process in a further implementation. In one implementation, one of the widths of the heater element and one of the widths of the cavity are the same. Widths are measured in lateral directions, whereby depths are measured in the respective vertical direction.

In one implementation, the resistance changing material includes phase change materials like $Ge_2Sb_2Te_5$ (GST). The resistance changing material is deposited in another implementation into the cavity by at least one of the group of PVD-process, CVD-process, or ALD-process, or solution based spin-on processes.

Further a system is disclosed which includes a host, and a memory device communicatively coupled to the host, the memory device having an integrated circuit of one of the aforementioned implementations.

Although specific implementations have been illustrated and described herein, it will be appreciated by those of ordinary skill in the art that a variety of alternate and/or equivalent implementations may be substituted for the specific embodiments shown and described without departing from the scope of the present invention. Furthermore, it will be appreciated by those of ordinary skill in the art that any combination of implementations and embodiments may be made without departing from the scope of the present invention.

## Brief Description of the Drawings

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description. The elements of the drawings are not necessarily to scale relative to each other. Like reference numerals designate corresponding similar parts.

Figure 1 is a block diagram illustrating one embodiment of a system.

Figure 2 is a block diagram illustrating one embodiment of a memory device.

Figure 3 illustrates a cross-sectional view of one embodiment of a phase change memory cell.

Figure 4a illustrates cross-sectional views of one embodiment of a phase change memory cell along lines AA and BB after forming first electrode (350) and a top view.

Figure 4b illustrates cross-sectional views of one embodiment of a phase change memory cell along lines AA and BB after depositing heater material (355) and dielectric material (370).

Figure 4c illustrates cross-sectional views of one embodiment of a phase change memory cell along lines AA and BB after planarization.

Figure 4d illustrates cross-sectional views of one embodiment of a phase change memory cell along lines AA and BB after depositing sacrificial materials (380) and (365).

Figure 4e illustrates cross-sectional views of one embodiment of a phase change memory cell along lines AA and BB after spacer-etch-process of sacrificial material (380).

Figure 4f illustrates cross-sectional views of one embodiment of a phase change memory cell along lines AA and BB after forming of heater element (355) and depositing and planarizing of dielectric material (362).

Figure 4g illustrates cross-sectional views of one embodiment of a phase change memory cell along lines AA and BB after structuring sacrificial material (380) and depositing and planarizing of dielectric material (364).

Figure 4h illustrates cross-sectional views of one embodiment of a phase change memory cell along lines AA and BB after removing of sacrificial material (380) and forming of cavity (321).

Figure 4i illustrates cross-sectional views of one embodiment of a phase change memory cell along lines AA and BB after filling of resistance changing material (320) into cavity (321).

Figure 4j illustrates cross-sectional views of one embodiment of a phase change memory cell along lines AA and BB after etch back of resistance changing material (320) and depositing of second electrode (310).

Figure 5a illustrates cross-sectional views of another embodiment of a phase change memory cell along lines AA and BB after depositing sacrificial material (365) and sacrificial material (380).

Figure 5b illustrates cross-sectional views of another embodiment of a phase change memory cell along lines AA and BB after spacer-etch-process of sacrificial material (380).

Figure 5c illustrates cross-sectional views of another embodiment of a phase change memory cell along lines AA and BB after forming of heater element (355) and depositing and planarizing of dielectric material (362).

Figure 5d illustrates cross-sectional views of another embodiment of a phase change memory cell along lines AA and BB after structuring sacrificial material (380) and depositing and planarizing of dielectric material (364).

Figure 5e illustrates cross-sectional views of another embodiment of a phase change memory cell along lines AA and BB after removing of sacrificial material (380) and forming of cavity (321).

Figure 5f illustrates cross-sectional views of another embodiment of a phase change memory cell along lines AA and BB after filling of resistance changing material (320) into and over cavity (321).

Figure 5g illustrates cross-sectional views of another embodiment of a phase change memory cell along lines AA and BB after depositing of second electrode (310).

Figure 5h illustrates cross-sectional views of another embodiment of a phase change memory cell along lines AA and BB after structuring of second electrode (310) and depositing and planarizing of dielectric material (366).

Figure 6 illustrates one embodiment of a method 600 for fabricating an integrated circuit.

## Detailed Description of the Invention

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims,

It is to be understood that the features of the various embodiments described herein may be combined with each other, unless specifically noted otherwise.

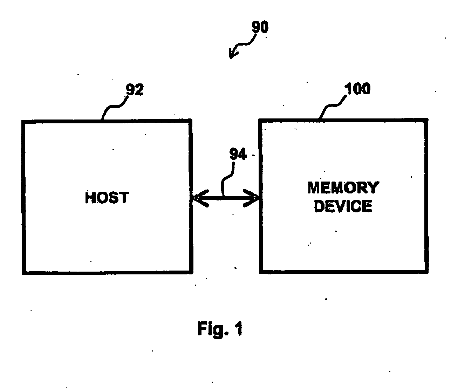

Figure 1 is a block diagram illustrating one embodiment of a system 90. System 90 includes a host 92 and a memory device 100. Host 92 is communicatively coupled to memory device 100 through communication link 94. Host 92 includes a microprocessor, computer (e.g., desktop, laptop, handheld), portable electronic device (e.g., cellular phone, personal digital assistant (PDA), MP3 player, video player, digital camera), or any other suitable device that uses memory. Memory device 100 provides memory for host 92. In one embodiment, memory device 100 includes a phase change memory device or other suitable resistive or resistivity changing material memory device.

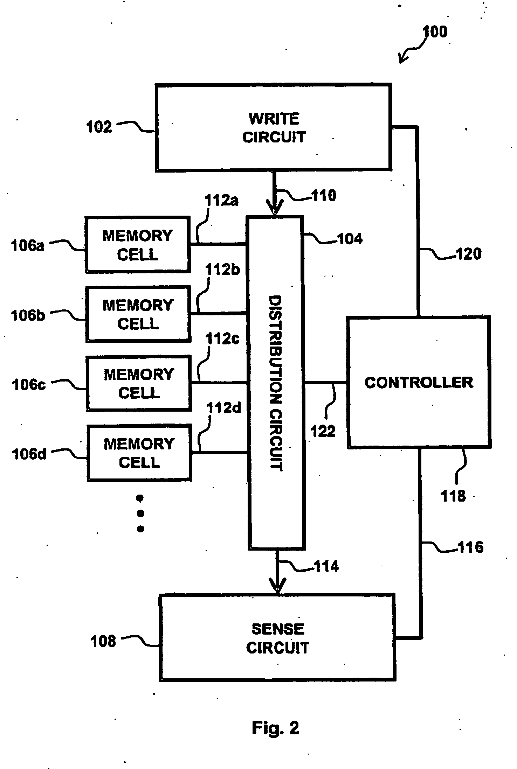

Figure 2 is a block diagram illustrating one embodiment of memory device 100. In one embodiment, memory device 100 is an integrated circuit or part of an integrated circuit. Memory device 100 includes a write circuit 102, a distribution circuit 104, memory cells 106a, 106b, 106c, and 106d, a controller 118, and a sense circuit 108. Each of the memory cells 106a-106d is a phase change memory cell that stores data based on the amorphous and crystalline states of phase change material in the memory cell. Also, each of the memory cells 106a-106d can be programmed into one of two or more states by programming the phase change material to have intermediate resistance values. To program one of the memory cells 106a-106d to an intermediate resistance value, the amount of crystalline material coexisting with amorphous material and hence the cell resistance is controlled using a suitable write strategy.

Each of the memory cells 106a-106d includes phase change material. The phase change material is deposited over a bottom electrode. The phase change material is deposited using chemical vapor deposition (CVD), atomic layer deposition (ALD), physical vapor deposition (PVD), solution based spin-on, or other suitable deposition technique.

As used herein, the term "electrically coupled" is not meant to mean that the elements must be directly coupled together and Intervening elements may be provided between the "electrically coupled" elements.

Write circuit 102 is electrically coupled to distribution circuit 104 though signal path 110. Distribution circuit 104 is electrically coupled to each of the memory cells 106a-106d through signal paths 112a-112d. Distribution circuit 104 is electrically coupled to memory cell 106a through signal path 112a. Distribution circuit 104 is electrically coupled to memory cell 106b through signal path 112b. Distribution circuit 104 is electrically coupled to memory cell 106c through signal path 112c. Distribution circuit 104 is electrically coupled to memory cell 106d through signal path 112d. Distribution circuit 104 is electrically coupled to sense circuit 108 through signal path 114. Sense circuit 108 is electrically coupled to controller 118 through signal path 116. Controller 118 is electrically coupled to write circuit 102 through signal path 120 and to distribution circuit 104 through signal path 122.

Each of the memory cells 106a-106d includes a phase change material that may be changed from an amorphous state to a crystalline state or from a crystalline state to an amorphous state under the influence of temperature change. The amount of crystalline phase change material coexisting with amorphous phase change material in one of the memory cells 106a-106d thereby defines two or more states for storing data within memory device 100.

In the amorphous state, a phase change material exhibits significantly higher resistivity than in the crystalline state. Therefore, the two or more states of memory cells 106a-106d differ in their electrical resistivity. In one embodiment, the two or more states include two states and a binary system is used, wherein the two states are assigned bit values of "0" and "1". In another embodiment, the two or more states include three states and a ternary system is used, wherein the three states are assigned bit values of "0", "1", and "2". In another embodiment, the two or more states include four states that are assigned multi-bit values, such as "00", "01", "10", and "11". In other embodiments, the two or more states can be any suitable number of states in the phase change material of a memory cell.

Controller 118 controls the operation of write circuit 102, sense circuit 108, and distribution circuit 104. Controller 118 includes a microprocessor, microcontroller, or other suitable logic circuitry for controlling the operation of write circuit 102, sense circuit 108, and distribution circuit 104. Controller 118 controls write circuit 102 for setting the resistance states of memory cells 106a-106d. Controller 118 controls sense circuit 108 for reading the resistance states of memory cells 106a-106d. Controller 118 controls distribution circuit 104 for selecting memory cells 106a-106d for read or write access. In one embodiment, controller 118 is embedded on the same chip as memory cells 106a-106d. In another embodiment, controller 118 is located on a separate chip from memory cells 106a-106d.

In one embodiment, write circuit 102 provides voltage pulses to distribution circuit 104 through signal path 110, and distribution circuit 104 controllably directs the voltage pulses to memory cells 106a-106d through signal paths 112a-112d. In another embodiment, write circuit 102 provides current pulses to distribution circuit 104 through signal path 110, and distribution circuit 104 controllably directs the current pulses to memory cells 106a-106d through signal paths 112a-112d. In one embodiment, distribution circuit 104 includes a plurality of transistors that controllably direct the voltage pulses or the current pulses to each of the memory cells 106a-106d. In another embodiment, distribution circuit 104 includes a plurality of diodes that controllably direct the voltage pulses or the current pulses to each of the memory cells 106a-106d.

Sense circuit 108 reads each of the two or more states of memory cells 106a-106d through signal path 114. Distribution circuit 104 controllably directs read signals between sense circuit 108 and memory cells 106a-106d through signal paths 112a-112d. In one embodiment, distribution circuit 104 includes a plurality of transistors that controllably direct read signals between sense circuit 108 and memory cells 106a-106d.

In one embodiment, to read the resistance of one of the memory cells 106a-106d, sense circuit 108 provides current that flows through one of the memory cells 106a-146d and sense circuit 108 reads the voltage across that one of the memory cells 106a-106d. In another embodiment, sense circuit 108 provides voltage across one of the memory cells 106a-106d and reads the current that flows through that one of the memory cells 106a-106d. In another embodiment, write circuit 102 provides voltage across one of the memory cells 106a-106d and sense circuit 108 reads the current that flows through that one of the memory cells 106a-106d. In another embodiment, write circuit 102 provides current through one of the memory cells 106a-106d and sense circuit 108 reads the voltage across that one of the memory cells 106a-106d.

To program a memory cell 106a-106d within memory device 100, write circuit 102 generates one or more current or voltage pulses for heating the phase change material in the target memory cell. In one embodiment, write circuit 102 generates appropriate current or voltage pulses, which are fed into distribution circuit 104 and distributed to the appropriate target memory cell 108a-106d. The amplitude and duration of the current or voltage pulses are controlled depending on whether the memory cell is being set or reset.

Generally, a "set" operation of a memory cell is heating the phase change material of the target memory cell above its crystallization temperature (but usually below its melting temperature) long enough to achieve the crystalline state or a partially crystalline and partially amorphous state. Generally, a "reset" operation of a memory cell is heating the phase change material of the target memory cell above its melting temperature, and then quickly quench cooling the material, thereby achieving the amorphous state or a partially amorphous and partially crystalline state.

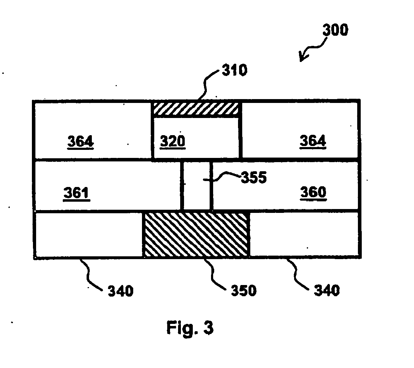

Figure 3 illustrates a cross-sectional view of one embodiment of a phase change memory cell 300. In one embodiment, each of the phase change memory cells 106a-106d previously described and illustrated with reference to Figure 2 is similar to phase change memory cell 300. Phase change memory cell 300 includes a first electrode 350, a heater element 355, a phase change element 320, a second electrode 310, and dielectric materials 340, 360, 361, and 364.

First electrode 350 includes TiN, TaN, W, Al, Ti, Ta, TiSiN, TaSiN, TiAlN, TaAlN, WN, C, CN, TaCN, or other suitable electrode material. The top of first electrode 350 contacts the bottom of heater element 355.

Heater element 355 includes TiN, TaN, W, Al, Ti, Ta, TiSiN, TaSiN, TiAlN, TaAlN, WN, C, CN, TaCN, or other suitable electrode material. The top of heater element 355 contacts the bottom of phase change material 320.

In one embodiment, phase change material of phase change element 320 comprises a phase change material that may be made up of a variety of materials. Generally, chalcogenide alloys that contain one or more elements from Group VI of the periodic table are useful as such materials. In one embodiment, the phase change material is made up of a chalcogenide compound material, such as GeSbTe (GST), SbTe, GeTe, AgInSbTe, $Ge_2Sb_2Te_5$, InSbTe, (GeSn)SbTe, GaSeTe, GeSb (SeTe), $SnSb_2Te_4$, $Te_{81}Ge_{15}Sb_2S_2$, or $Sb_2Te_3$. In another embodiment, the phase change material is chalcogen free, such as GeSb, GaSb, InSb, or GeGaInSb, InSe, or InSbGe, In further embodiments, Bi replaces Sb in the aforementioned materials. In other embodiments, the phase change material is made up of any suitable material including one or more of the elements Ge, Sb, Te, Ga, As, In, Ge, Se, Ag, Bi, and S.

The phase change material of phase change element 320 is deposited using chemical vapor deposition (CVD), atomic layer deposition (ALD), physical vapor deposition (PVD), solution based spin-on, or other suitable deposition technique.

The top of phase change element 320 contacts the bottom of second electrode 310. Second electrode 310 includes TiN, TaN, W, Al, Ti, Ta, TiSiN, TaSiN, TiAlN, TaAlN, WN, C, CN, TaCN, or other suitable electrode material. Dielectric material 340 laterally surrounds first electrode 350. Dielectric material 340 includes $SiO_2$, $SiO_x$, SiN, SiON, $AlO_x$, fluorinated silica glass (FSG), boro-phosphorus silicate glass (BPSG), boro-silicate glass (BSG), or other suitable dielectric material. Dielectric materials 360, 361, and 364 include $SiO_2$, $SiO_x$, SiN, SiON, $AlO_x$, fluorinated silica glass (FSG), boro-phosphorus silicate glass (BPSG), boro-silicate glass (BSG), or other suitable dielectric material.

Phase change element 320 provides a storage location for storing one or more bits of data. During operation of memory cell 300, current or voltage pulses are applied between first electrode 350 and second electrode 310 to program the memory cell.

During a "sent" operation of memory cell 300, one or more set current or voltage pulses are selectively enabled by write circuit 102 and sent to first electrode 350 or second electrode 310. From first electrode 350 or second electrode 310, the set current or voltage pulses pass through phase change element 320 thereby heating the phase change material above its crystallization temperature (but usually below its melting temperature). In this way, the phase change material reaches a crystalline state or a partially crystalline and partially amorphous state during the "set" operation.

During a "reset" operation of memory cell 300, a reset current or voltage pulse is selectively enabled by write circuit 102 and sent to first electrode 350 or second electrode 310. From first electrode 350 or second electrode 310, the reset current or voltage pulse passes through phase change element 320. The reset current or voltage quickly heats the phase change material above its melting temperature. After the current or voltage pulse is turned off, the phase change material quickly quench cools into an amorphous state or a partially amorphous and partially crystalline state.

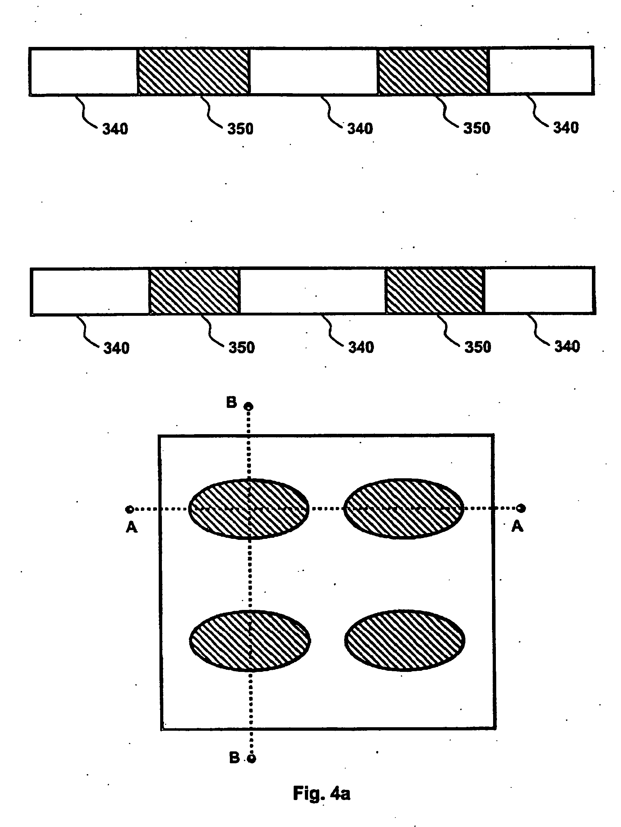

Figures 4a-4j illustrate a process flow to manufacture an integrated circuit including resistance changing material 320 below a minimum feature size of 46nm. The invention can also be applied to minimum feature sizes equal or greater 46nm.

Figure 4a illustrates cross-sectional views of one embodiment of a phase change memory cell along lines AA and BB after forming first electrode 350 and a top view. The lines AA and BB are indicated in the top view. In one embodiment, first electrodes 350 are formed by using double patterning or self-aligned pitch fragmentation techniques on a semiconductor substrate. In another embodiment, first electrodes 350 are formed by a conventional lithography process printing holes and/or ellipses on a semiconductor substrate.

Substrate includes Si substrate, Si on insulator (SOI) substrate, or other suitable substrate. In one embodiment, the substrate is pre-processed and includes select devices or other devices. In one embodiment, the substrate includes select devices 108, such as transistors of any type (e.g., FET or bipolar transistors) or diodes. In another embodiment, the substrate includes other suitable devices for semiconductor manufacturing like buried lines, etc.

In one implementation, first electrode 350 is formed by depositing using chemical vapor deposition (CVD), high density plasma-chemical vapor deposition (HDP-CVD), atomic layer deposition (ALD), metal organic chemical vapor deposition (MOCVD), physical vapor deposition (PVD), jet vapor deposition (JVD), or other suitable deposition technique. First electrode 350 includes TiN, TaN, W, Al, Ti, Ta, TiSiN, TaSiN, TiAlN, TaAlN, WN, C, CN, TaCN, or other suitable electrode material.

Dielectric material 340 is deposited using CVD, HDP-CVD, ALD, MOCVD, PVD, JVD, or other suitable deposition technique. Dielectric material 340 includes $SiO_2$. $SiO_x$, SiN, SiON, $AlO_x$, fluorinated silica glass (FSG), boro-phosphorus silicate glass (BPSG), boro-silicate glass (BSG), or other suitable dielectric material.

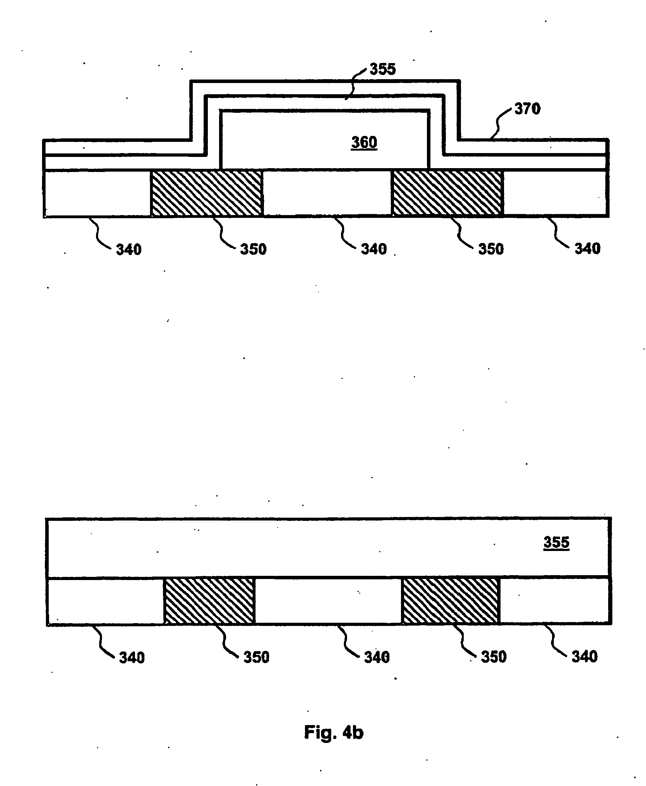

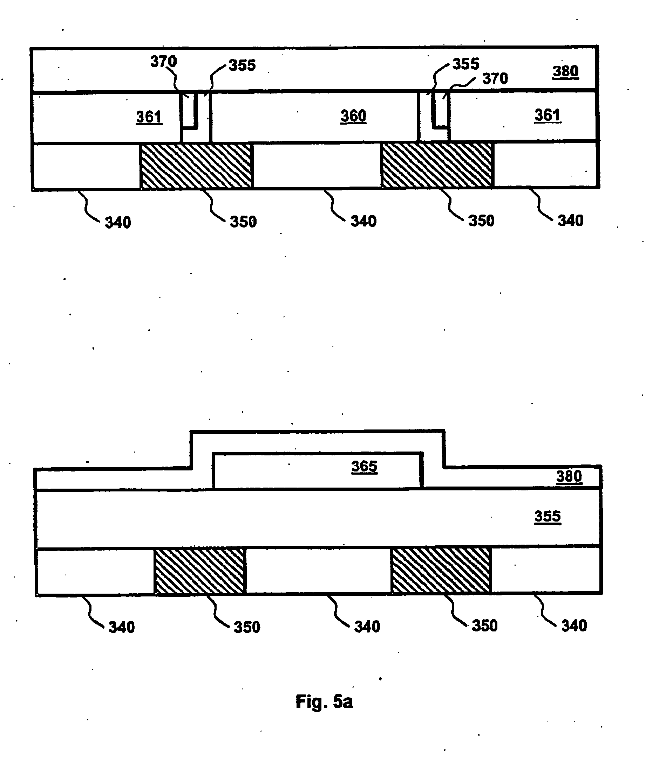

For the following Figures 4b-4j and 5a-5h each top figure represents the cross-sectional view along line AA and each bottom figure represents the cross-sectional view along line BB.

Figure 4b illustrates cross-sectional views of one embodiment of a phase change memory cell along lines AA and BB after depositing heater material 355 and dielectric material 370. Starting with the structure of Figure 4a dielectric material 360 is deposited over first electrode 350 and dielectric material 340.

Dielectric material 360 is deposited using CVD, HDP-CVD, ALD, MOCVD, PVD, JVD, or other suitable deposition technique. Dielectric material 360 includes $SiO_2$ $SiO_x$, SiN, SiON, $AlO_x$, fluorinated silica glass (FSG), boro-phosphorus silicate glass (BPSG), boro-silicate glass (BSG), or other suitable dielectric material.

Dielectric material 360 is structured by means of a line-lithography-process. Line-lithography-process is a lithography process which utilizes the printing of lines. Typically, patterns of parallel lines are printed with line-lithography-processes. In contrast to conventional lithography which may print holes, line-lithography extends the range of minimum feature size below 46nm. The invention can also be applied to minimum feature sizes equal or greater 46nm.

Structuring by means of line-lithography includes depositing a photoresist (PR) over a material, exposing the photoresist with a line pattern, developing the photoresist to remove either exposed or not exposed parts of the photoresist, and structuring the material by using the structured photoresist as a mask.

Heater material 355 is deposited over dielectric material 360, first electrode 350, and dielectric material 340 using CVD, HDP-CVD, ALD, MOCVD, PVD, JVD, or other suitable deposition technique. Heater material 355 includes TiN, TaN, W, Al, Ti, Ta, TiSiN, TaSiN, TiAlN, TaAlN, WN, C, CN, TaCN, or other suitable electrode material.

In one embodiment, dielectric material 370 is deposited over heater material 355 using CVD, HDP-CVD, ALD, MOCVD, PVD, JVD, or other suitable deposition technique. Dielectric material 370 includes $SiO_2$, $SiO_x$, SiN, SiON, $AlO_x$, fluorinated silica glass (FSG), boro-phosphorus silicate glass (BPSG), boro-silicate glass (BSG), or other suitable dielectric material.

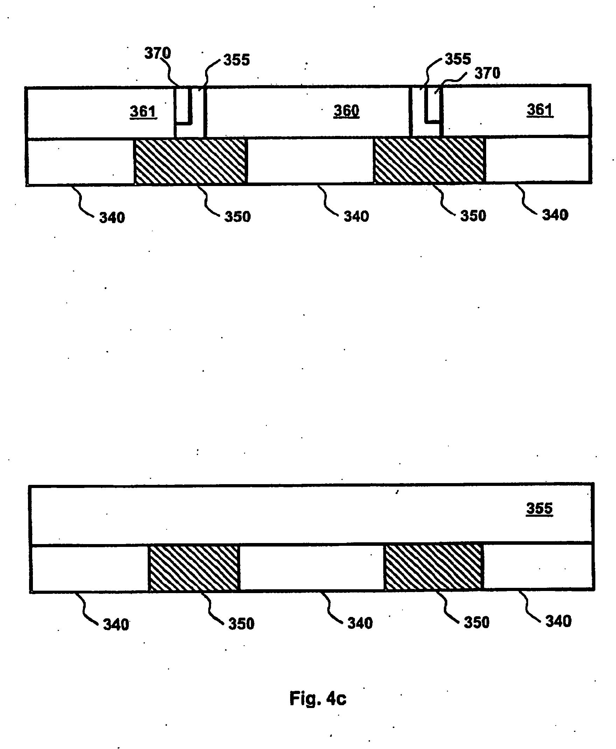

Figure 4c illustrates cross-sectional views of one embodiment of a phase change memory cell along lines AA and BB after planarization. Starting with the structure of Figure 4b an anisotropic etch process etches dielectric material 370 and heater material 355 (so called "spacer-etch-process"). In one embodiment, anisotropic etch process is a plasma based process or any other suitable etching technique.

Spacer-etch-process is a typical process for semiconductor manufacturing and is widely used, e.g. for gate spacers etc. A structure with side-faces and top-faces is conformally covered by a layer. The layer is etched anisotropically. On planar surfaces - like the top-face - the layer is removed; only on the side-faces of the structure parts of the layer are remaining. The remaining parts of the layer covering the side-faces of the structure are called "spacers".

Dielectric material 361 is deposited over the remaining parts of dielectric material 370 and heater material 355 and over dielectric material 360 using CVD, HDP-CVD, ALD, MOCVD, PVD, JVD, or other suitable deposition technique. In one embodiment, SiN is chosen as dielectric material 361. Dielectric material 361 further includes $SiO_2$, $SiO_x$, SiON, $AlO_x$, fluorinated silica glass (FSG), boro-phosphorus silicate glass (BPSG), boro-silicate glass (BSG), or other suitable dielectric material.

The structure illustrated in Figure 4c is obtained after planarizing. Planarizing is used for removing parts of dielectric material 361. In one embodiment, chemical mechanical planarization (CMP) is used or other suitable planarization techniques. In one embodiment, parts of dielectric material 361, dielectric material 360, dielectric material 370, and heater material 355 are removed by planarizing.

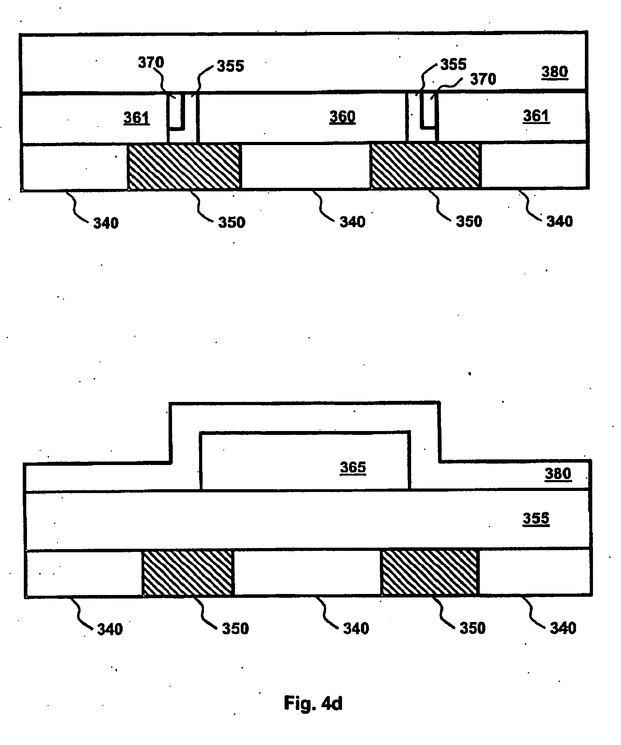

Figure 4d illustrates cross-sectional views of one embodiment of a phase change memory cell along lines AA and BB after depositing sacrificial materials 380 and 365. Starting with the structure of Figure 4c sacrificial material 365 is deposited.

Sacrificial material 365 is deposited using CVD, HDP-CVD, ALD, MOCVD, PVD, JVD, or other suitable deposition technique. In one embodiment, C is chosen as sacrificial material 365. Sacrificial material 365 further includes $SiO_2$, $SiO_x$, SiN, SiON, $AlO_x$, fluorinated silica glass (FSG), boro-phosphorus silicate glass (BPSG), boro-silicate glass (BSG), or other suitable dielectric material.

Sacrificial material 365 is structured by means of a line-lithography-process. Line-lithography-process is a lithography process which utilizes the printing of lines. Typically, patterns of parallel lines are printed with line-lithography-processes. In contrast to conventional lithography which may print holes, line-lithography extends the range of minimum feature size below 46nm. The invention can also be applied to minimum feature sizes equal or greater 46nm.

Structuring by means of line-lithography includes depositing a photoresist (PR) over a material, exposing the photoresist with a line pattern, developing the photoresist to remove either exposed or not exposed parts of the photoresist, and structuring the material by using the structured photoresist as a mask.

Sacrificial material 380 Is deposited using CVD, HDP-CVD, ALD, MOCVD, PVD, JVD, or other suitable deposition technique. In one embodiment, poly-Si is chosen as sacrificial material 380. Sacrificial material 380

further includes $SiO_2$, $SiO_x$, SiN, SiON, $AlO_x$, fluorinated silica glass (FSG), boro-phosphorus silicate glass (BPSG), boro-silicate glass (BSG), C, amorphous-Si, or other suitable dielectric material.

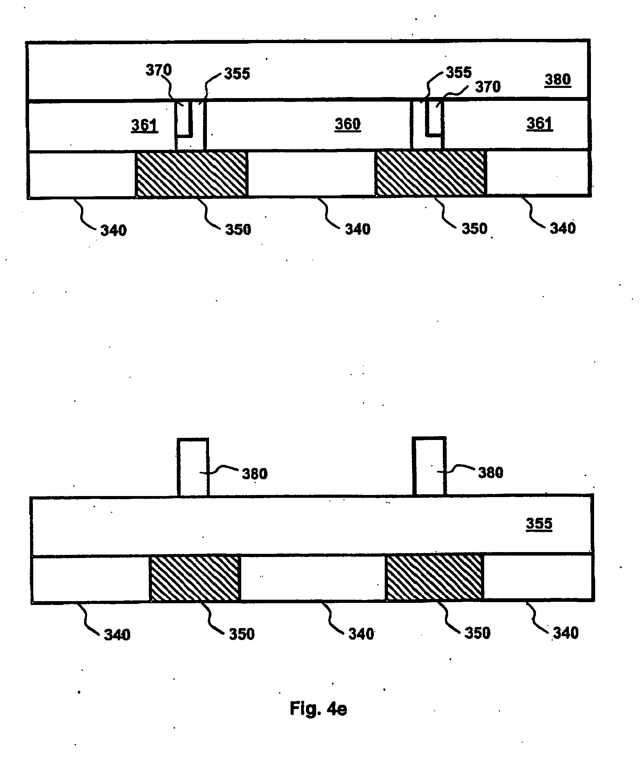

Figure 4e illustrates cross-sectional views of one embodiment of a phase change memory cell along lines AA and BB after spacer-etch-process of sacrificial material 380. Starting with the structure of Figure 4d an anisotropic etch-process etches dielectric material 380 (so called "spacer-etch-process"). In one embodiment, anisotropic etch process is a plasma based process or any other suitable etching technique. The dimensioning of heater element 355 is determined by the sidewall thickness of sacrificial material 380.

Sacrificial material 365 is removed using wet etch technique, or other suitable removal techniques.

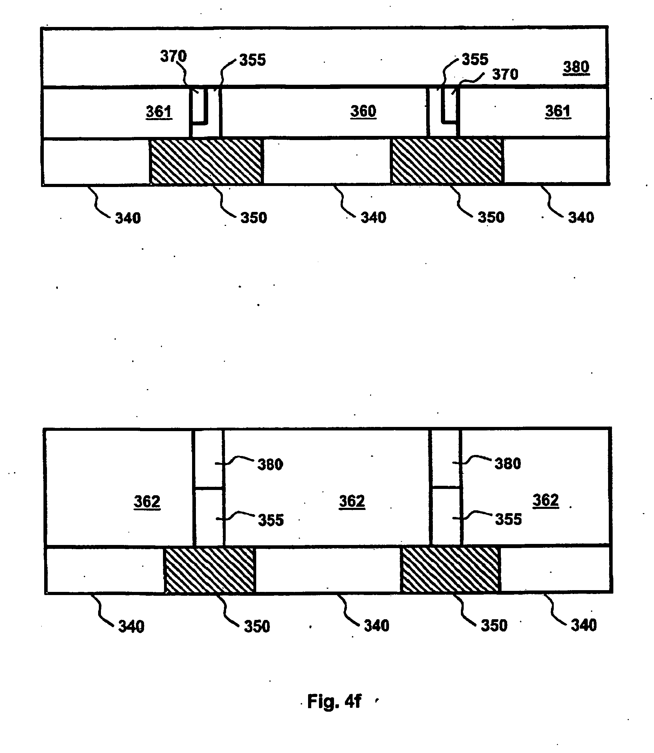

Figure 4f illustrates cross-sectional views of one embodiment of a phase change memory cell along lines AA and BB after forming of heater element 355 and depositing and planarizing of dielectric material 362. Starting with the structure of Figure 4e an anisotropic etch-process etches heater element 355. In one embodiment, anisotropic etch process is a plasma based process or any other suitable etching technique.

Dielectric material 362 is deposited using CVD, HDP-CVD, ALD, MOCVD, PVD, JVD, or other suitable deposition technique. In one embodiment, SiN is chosen as dielectric material 362. Dielectric material 362 further includes $SiO_2$, $SiO_x$, SiON, $AlO_x$, fluorinated silica glass (FSG), boro-phosphorus silicate glass (BPSG), boro-silicate glass (BSG), or other suitable dielectric material.

Dielectric material 362 is planarized by using chemical mechanical planarization (CMP) in one embodiment. Other suitable planarization techniques are used in other embodiments. In one embodiment, parts of sacrificial material 380 are removed by the planarizing.

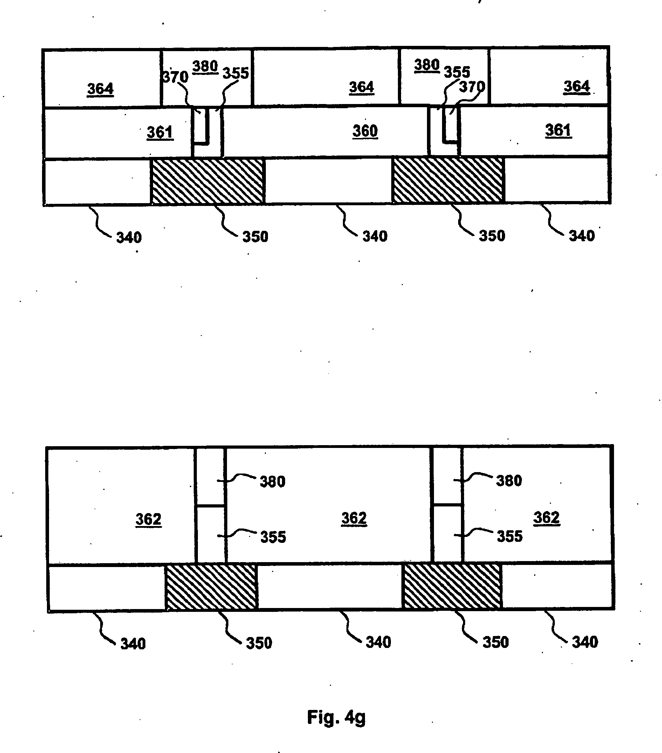

Figure 4g illustrates cross-sectional views of one embodiment of a phase change memory cell along lines AA and BB after structuring sacrificial material 380 and depositing and planarizing of dielectric material 364.

In one embodiment, sacrificial material 380 is structured by means of a line-lithography-process. Line-lithography-process is a lithography process which utilizes and prints lines. Typically, patterns of parallel lines are printed with line-lithography-processes. In contrast to conventional lithography which may print holes, line-lithography extends the range of minimum feature size below 46nm. The invention can also be applied to minimum feature sizes equal or greater 46nm. In another embodiment, sacrificial material 380 is structured by a space-etch-process, or other suitable etch process.

Structuring by means of line-lithography includes depositing a photoresist (PR) over a material, exposing the photoresist with a line pattern, developing the photoresist to remove either exposed or not exposed parts of the photoresist, and structuring the material by using the structured photoresist as a mask.

Dielectric material 364 is deposited using CVD, HDP-CVD, ALD, MOCVD, PVD, JVD, or other suitable deposition technique. In one embodiment, SiN is chosen as dielectric material 364. Dielectric material 364.further includes $SiO_2$, $SiO_x$, SiON, $AlO_x$, fluorinated silica glass (FSG), boro-phosphorus silicate glass (BPSG), boro-silicate glass (BSG), or other suitable dielectric material.

Dielectric material 364 is planarized by using chemical mechanical planarization (CMP) in one embodiment. Other suitable planarization techniques are used in other embodiments. In one embodiment, parts of sacrificial material 380 are removed by the planarizing.

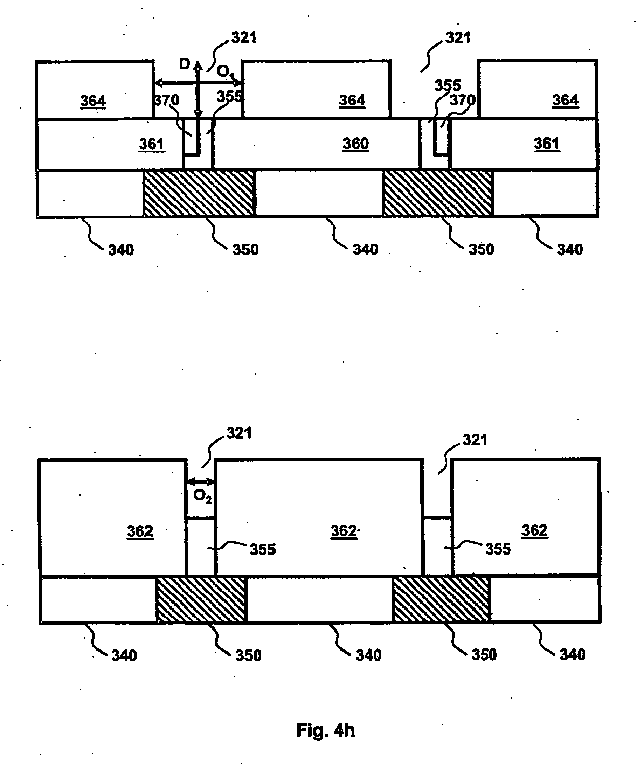

Figure 4h illustrates cross-sectional views of one embodiment of a phase change memory cell along lines AA and BB after removing of sacrificial material 380 and forming of cavity 321. Cavity 321 has an opening $O_1$, in AA-direction, an opening $O_2$ in BB-direction, and a depth of $D$. The aspect ratios $AR_1$ and $AR_2$ of cavity 321 are defined as follows:

$$AR_1 = \frac{D}{O_1} \quad \text{and} \quad AR_2 = \frac{D}{O_2}.$$

Cavity 321 is formed by removing of sacrificial material 380. Sacrificial material 380 is removed using wet etch technique, or other suitable removal techniques. In one embodiment, the aspect ratios of cavity 321 are $AR_1 \sim 1$ and $AR_2 \sim 3$.

Cavity 321 is laterally surrounded by dielectric materials 362 and 364. Neighboring cavities 321 - as illustrated in Figure 4h for two cavities 321 - are laterally isolated against each other. Isolated is referred to a spatial meaning which results into electrical, thermal, or other isolation.

The lateral cross-section of cavity 321 is illustrated in Figure 4h with rectangular shape with side widths of $O_1$ in AA-direction, an $O_2$ in BB-direction. In a real process flow, deviations from this shape will occur. The rectangular shape might have rounded edges and might even merge into an ellipse shape.

In the illustrated embodiment, heater element 355 is L-shaped with a larger contact area towards the first electrode 350 compared to the contact area towards the cavity 321.

The sidewall thickness of sacrificial material 380 determines the dimensioning of heater element 355. Cavity 321 has an opening $O_2$ in BB-direction which is the same dimension as the dimension of the heater element 355 in BB-direction. Sacrificial material 380 is utilized to form cavity 321 and to mask the structuring of heater element 355.

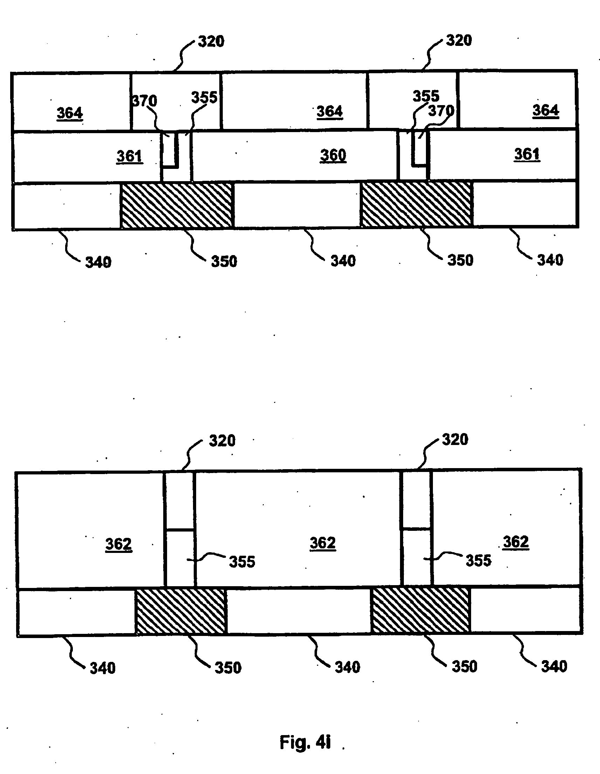

Figure 4i illustrates cross-sectional views of one embodiment of a phase change memory cell along lines AA and BB after filling of resistance changing material 320 into cavity 321.

In one embodiment, phase change material 320 is deposited using chemical vapor deposition (CVD) or atomic layer deposition (ALD). Both techniques are suited to fill structures with aspect ratios $AR_1$ and $AR_2$ as mentioned here. In other embodiments, phase change material 320 Is deposited using physical vapor deposition (PVD), solution based spin-on, or other suitable deposition technique. Phase change material 320 is planarized by using by chemical mechanical planarization (CMP) in one embodiment. Other suitable planarization techniques are used in other embodiments.

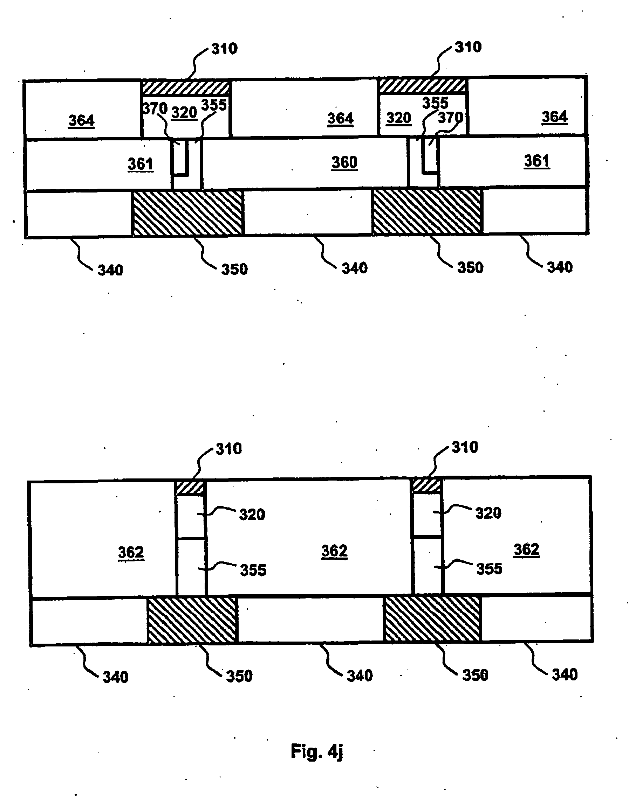

Figure 4j illustrates cross-sectional views of one embodiment of a phase change memory cell along lines AA and BB after etch back of phase change material 320 and depositing of second electrode 310.

In one embodiment, phase change material 320 is etched back by a wet etch process using a fluid to remove phase change material 320 selectively against dielectric material 364 and dielectric material 362. Other suitable etch techniques are used in other embodiments.

Second electrode material 310 is deposited using chemical vapor deposition (CVD), atomic layer deposition (ALD), physical vapor deposition (PVD), solution based spin-on, or other suitable deposition technique. Second electrode material 310 includes TiN, TaN, W, Al, Ti, Ta, TiSiN, TaSiN, TiAlN, TaAlN, WN, C, CN, TaCN, or other suitable electrode material. Second electrode 310 is planarized by using by chemical mechanical planarization (CMP) in one embodiment. Other suitable planarization techniques are used in other embodiments.

In a further embodiment, Instead of back-etching phase change material 320, a direct deposition of the second electrode material 310 is done, followed by the deposition of a bit line material such as W or Al. Both deposited materials are subsequently patterned forming the bit lines.

Another embodiment of a process sequence is illustrated in Figures 5a-5h. The first part of forming integrated circuit 100 is analog to the process sequence illustrated in Figures 4a-4c.

Figure 5a illustrates cross-sectional views of another embodiment of a phase change memory cell along lines AA and BB after depositing sacrificial material 365 and sacrificial material 380. Difference with respect to the illustration of Figure 4d is that the thickness of sacrificial material 365 is smaller. The thickness of sacrificial material 365 determines the height of spacer formed by sacrificial material 380 and the aspect ratio of cavity 321.

Sacrificial material 365 is deposited using CVD, HDP-CVD, ALD, MOCVD, PVD, JVD, or other suitable deposition technique. Sacrificial material 365 includes $SiO_2$. $SiO_x$, SiN, SiON, $AlO_x$, fluorinated silica glass (FSG), boro-phosphorus silicate glass (BPSG), boro-silicate glass (BSG), or other suitable dielectric material.

Sacrificial material 365 is structured by means of a line-lithography-process. Line-lithography-process is a lithography process which utilizes and prints lines. Typically, patterns of parallel lines are printed with line-lithography-processes. In contrast to conventional lithography which may print holes, line-lithography in conjunction with spacer-based pitch fragmentation extends the range of minimum feature size below 46nm. The invention can also be applied to minimum feature sizes equal or greater 46nm.

Structuring by means of line-lithography includes depositing a photoresist (PR) over a material, exposing the photoresist with a line pattern, developing the photoresist to remove either exposed or not exposed parts of the photoresist, and structuring the material by using the structured photoresist as a mask.

Spacer-based pitch fragmentation means the deposition of a carrier structure with side-walls and top-walls. Spacers are formed at the side-walls of the carrier structure by a spacer-etch-process. For a line-by-spacer technique, these spacers are used as mask for further processing. The line width is determined by the spacer thickness. For a line-by-fill technique, filling material is deposited between adjacent spacers and this material together with the carrier material is used as mask for further processing.

Sacrificial material 380 is deposited using CVD, HDP-CVD, ALD, MOCVD, PVD, JVD, or other suitable deposition technique. Sacrificial material 380 includes $SiO_2$, $SiO_x$, SiN, SiON, $AlO_x$, fluorinated silica glass (FSG), boro-phosphorus silicate glass (BPSG), boro-silicate glass (BSG), or other suitable dielectric material.

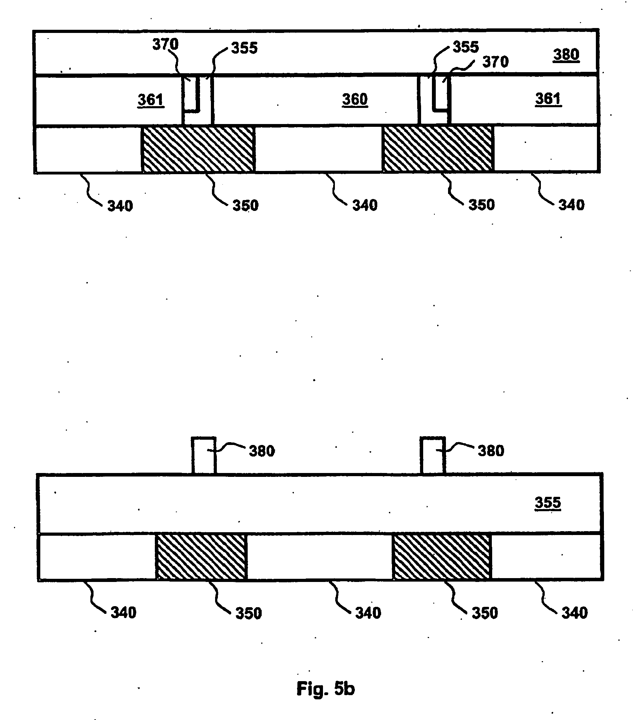

Figure 5b illustrates cross-sectional views of another embodiment of a phase change memory cell along lines AA and BB after spacer-etch-process of sacrificial material 380. Starting with the structure of Figure 5a an anisotropic etch-process etches dielectric material 380 (so called "spacer-etch-process"). In one embodiment, anisotropic etch process is a plasma based process or any other suitable etching technique. The dimensioning of heater element 355 is determined by the sidewall thickness of sacrificial material 380.

Sacrificial material 365 is removed using wet etch technique, or other suitable removal techniques.

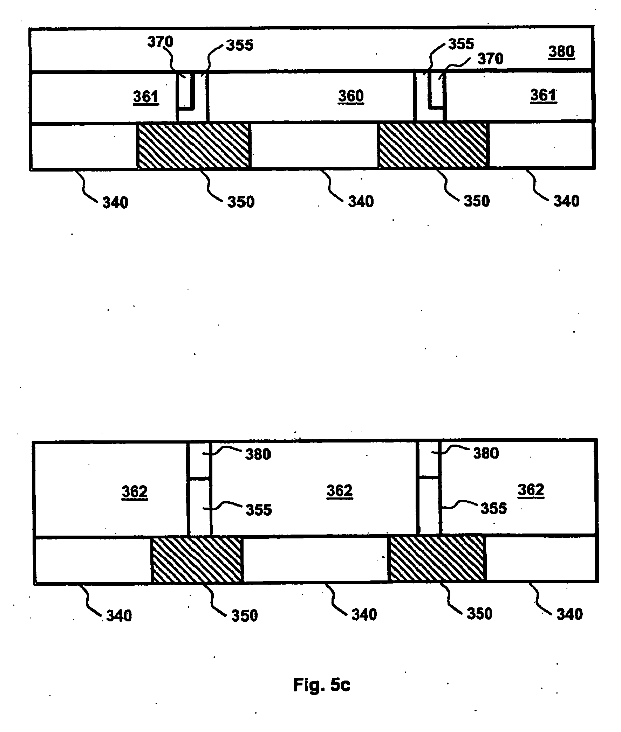

Figure 5c illustrates cross-sectional views of another embodiment of a phase change memory cell along lines AA and BB after forming of heater element 355 and depositing and planarizing of dielectric material 362. Starting with the structure of Figure 5b an anisotropic etch-process'etches heater element 355. In one embodiment, anisotropic etch process is a plasma based process or any other suitable etching technique.

Dielectric material 362 is deposited using CVD, HDP-CVD, ALD, MOCVD, PVD, JVD, or other suitable deposition technique. Dielectric material 362 includes $SiO_2$, $SiO_x$, SiN, SiON, $AlO_x$, fluorinated silica glass (FSG), boro-phosphorus silicate glass (BPSG), boro-silicate glass (BSG), or other suitable dielectric material.

Dielectric material 362 is planarized by using by chemical mechanical planarization (CMP) in one embodiment. Other suitable planarization techniques are used in other embodiments. In one embodiment, parts of sacrificial material 380 are removed by the planarizing.

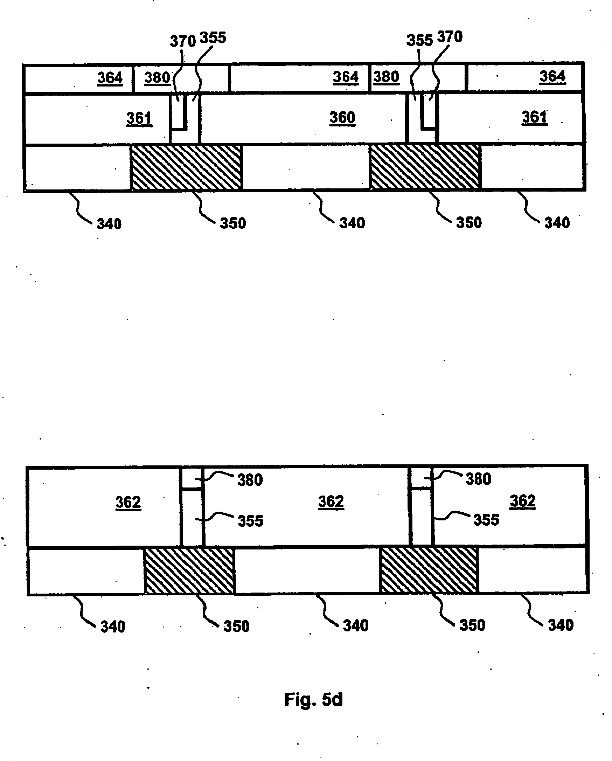

Figure 5d illustrates cross-sectional views of another embodiment of a phase change memory cell along lines AA and BB after structuring sacrificial material 380 and depositing and planarizing of dielectric material 364.

In one embodiment, sacrificial material 380 is structured by means of a line-lithography-process. Line-lithography-process is a lithography process which utilizes and prints lines. Typically, patterns of parallel lines are printed with line-lithography-processes. In contrast to conventional lithography which may print holes, line-lithography in conjunction with spacer-based pitch-fragmentation extends the accessible minimum feature size below 46nm. The invention can also be applied to minimum feature sizes equal or greater 46nm.

Structuring by means of line-lithography includes depositing a photoresist (PR) over a material, exposing the photoresist with a line pattern, developing the photoresist to remove either exposed or not exposed parts of the photoresist, and structuring the material by using the structured photoresist as a mask.

In another embodiment, sacrificial material 380 is structured by a space-etch-process, or other suitable etch process.

Dielectric material 364 is deposited using CVD, HDP-CVD, ALD, MOCVD, PVD, JVD, or other suitable deposition technique. Dielectric material 364includes $SiO_2$, $SiO_x$, SiN, SiON, $AlO_x$, fluorinated silica glass (FSG), boro-phosphorus silicate glass (BPSG), boro-silicate glass (BSG), or other suitable dielectric material.

Dielectric material 364 is planarized by using by chemical mechanical planarization (CMP) in one embodiment. Other suitable planarization techniques are used in other embodiments. In one embodiment, parts of sacrificial material 380 are removed by the planarizing.

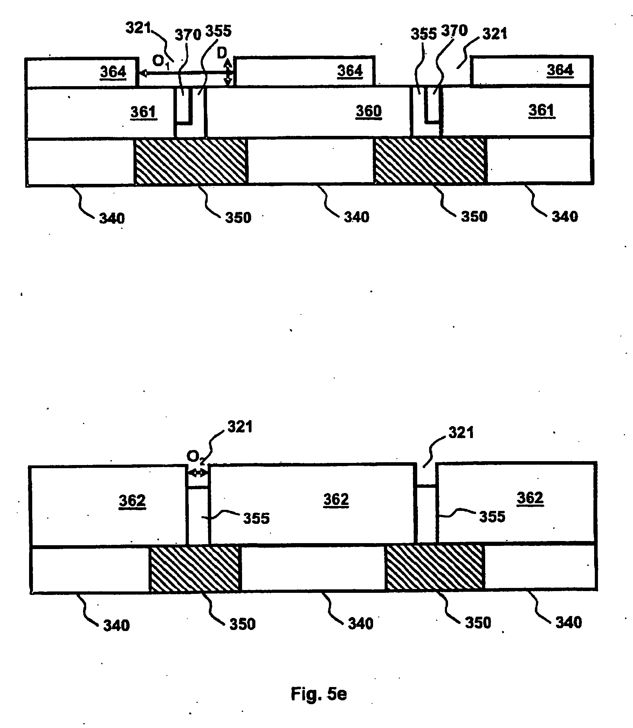

Figure 5e illustrates cross-sectional views of another embodiment of a phase change memory cell along lines AA and BB after removing of sacrificial material 380 and forming of cavity (321). Cavity 321 has an opening $O_1$ in AA-direction, an opening $O_2$ in BB-direction, and a depth of $D$. The aspect ratios $AR_1$ and $AR_2$ of cavity 321 are defined as follows:

$$AR_1 = \frac{D}{O_1} \quad \text{and} \quad AR_2 = \frac{D}{O_2}.$$

Cavity 321 is formed by removing of sacrificial material 380. Sacrificial material 380 is removed using wet etch technique, or other suitable removal techniques. In one embodiment, the aspect ratios of cavity 321 are $AR_1 \sim 1/3$ and $AR_2 \sim 1$.

Cavity 321 is laterally surrounded by dielectric materials 362 and 364. Neighboring cavities 321 - as illustrated in Figure 5e for two cavities 321 - are laterally isolated against each other. Isolated is referred to a spatial meaning which results into electrical, thermal, or other isolation.

The lateral cross-section of cavity 321 is illustrated in Figure 5e with rectangular shape with side widths of $O_1$ in AA-direction, an $O_2$ in BB-direction. In a real process flow, deviations from this shape will occur. The rectangular shape might have rounded edges and might even merge into an ellipse shape.

In the illustrated embodiment, heater element 355 is L-shaped with a larger contact area towards the first electrode 350 compared to the contact area towards the cavity 321.

The sidewall thickness of sacrificial material 380 determines the dimensioning of heater element 355. Cavity 321 has an opening $O_2$ in BB-direction which is the same dimension as the dimension of the heater element 355 in BB-direction. Sacrificial material 380 is utilized to form cavity 321 and to mask the structuring of heater element 355.

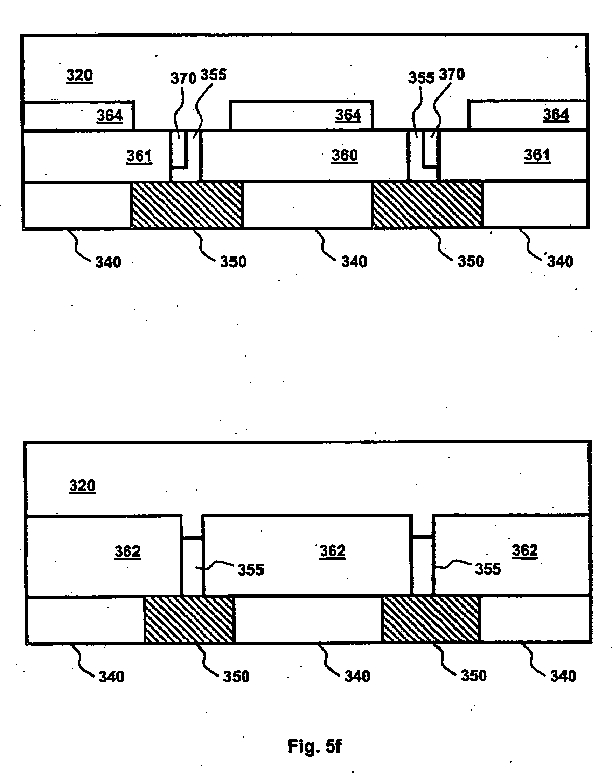

Figure 5f illustrates cross-sectional views of another embodiment of a phase change memory cell along lines AA and BB after filling of resistance changing material 320 into and over cavity 321.

In one embodiment, phase change material 320 is deposited using physical vapor deposition (PVD) which is suited to fill structures with aspect ratios $AR_1$ and $AR_2$ as mentioned here. In other embodiments, phase change material 320 is deposited using chemical vapor deposition (CVD), atomic layer deposition (ALD), solution based spin-on, or other suitable deposition technique. Phase change material 320 is planarized by using by chemical mechanical planarization (CMP) in one embodiment. Other suitable planarization techniques are used in other embodiments.

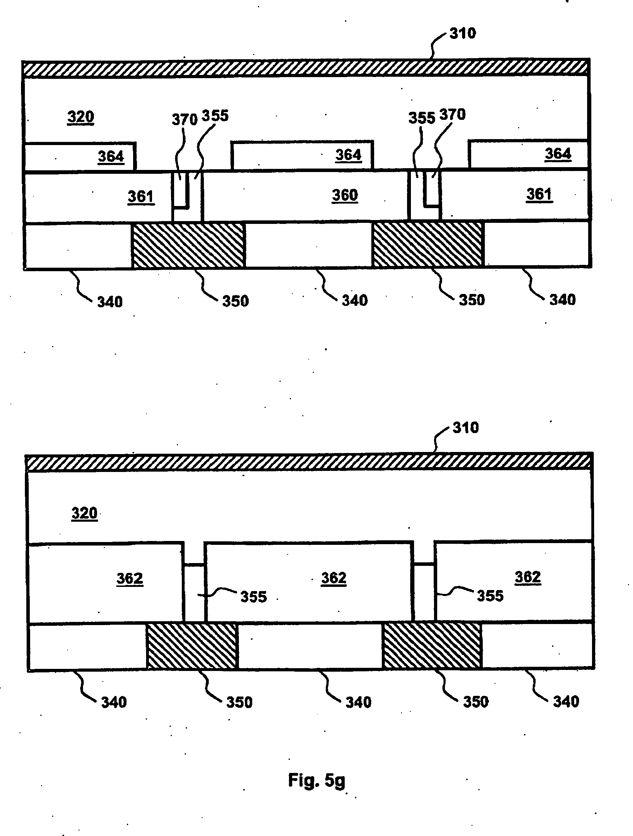

Figure 5g illustrates cross-sectional views of another embodiment of a phase change memory cell along lines AA and BB after depositing of second electrode 310.

Second electrode material 310 is deposited using chemical vapor deposition (CVD), atomic layer deposition (ALD), physical vapor deposition (PVD), solution based spin-on, or other suitable deposition technique. Second electrode material 310 includes TiN, TaN, W, Al, Ti, Ta, TiSiN, TaSiN, TiAlN, TaAlN, WN, C, CN, TaCN, or other suitable electrode material.

In one embodiment, second electrode material 310 is planarized by using by chemical mechanical planarization (CMP). Other suitable planarization techniques are used in other embodiments.

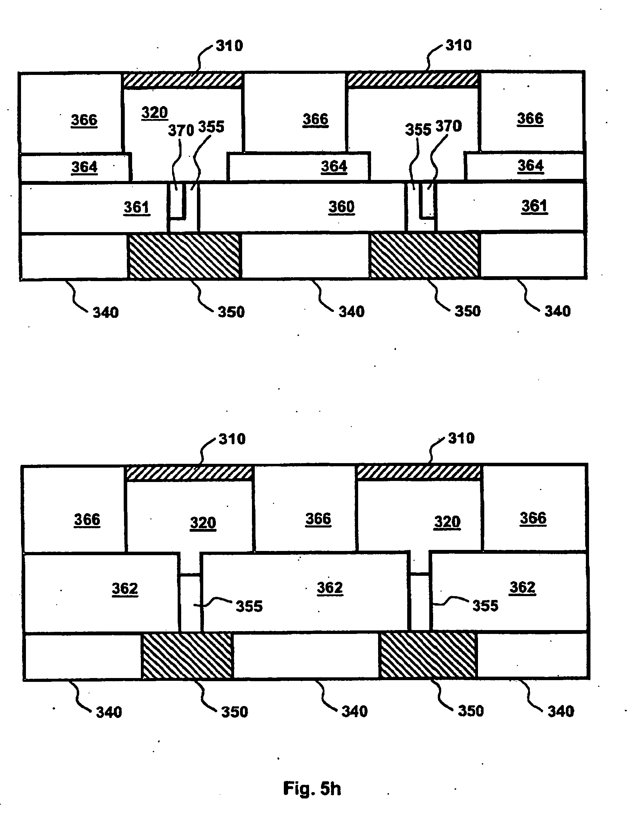

Figure 5h illustrates cross-sectional views of another embodiment of a phase change memory cell along lines AA and BB after structuring of second electrode 310 and depositing and planarizing of dielectric material 366.

In one embodiment, second electrode 310 is structured by means of a line-lithography-process. Line-lithography-process is a lithography process which utilizes and prints lines. Typically, patterns of parallel lines are printed with line-lithography-processes. In contrast to conventional lithography which may print holes, line-lithography in conjunction with spacer-based pitch-fragmentation extends the accessible minimum feature size below 46nm. The invention can also be applied to minimum feature sizes equal or greater 46nm. In another embodiment, second electrode 310 is structured by a space-etch-process, a conventional lithography-process, or other suitable etch process.

Structuring by means of line-lithography includes depositing a photoresist (PR) over a material, exposing the photoresist with a line pattern, developing the photoresist to remove either exposed or not exposed parts of the photoresist, and structuring the material by using the structured photoresist as a mask.

Dielectric material 366 is deposited using chemical vapor deposition (CVD), high density plasma-chemical vapor deposition (HDP-CVD), atomic layer deposition (ALD), physical vapor deposition (PVD), solution based spin-on, or other suitable deposition technique. Dielectric material 366 includes $SiO_2$, $SiO_x$, SiN, SiON, $AlO_x$, fluorinated silica glass (FSG), boro-phosphorus silicate glass (BPSG), boro-silicate glass (BSG), or other suitable dielectric material.

Dielectric material 366 is planarized by using by chemical mechanical planarization (CMP) in one embodiment. Other suitable planarization techniques are used in other embodiments.

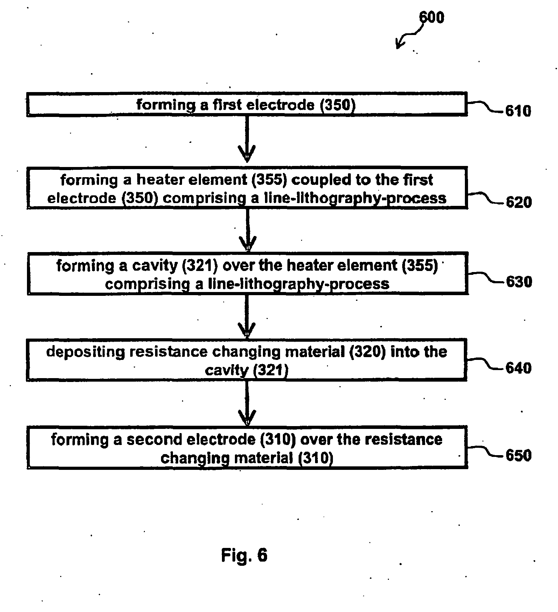

Figure 6 illustrates one embodiment of a method 600 for fabricating an integrated circuit. At 610, a first electrode 350 is formed. At 620, a heater element 355 is formed which is coupled to the first electrode 350 and includes a line-lithography-process during manufacturing. At 630, a cavity 321 is formed over the heater element 355 which includes a line-lithography-process during manufacturing. At 640, resistance changing material 320 is deposited into the cavity 321. At 650, a second electrode 310 is formed over the resistance changing material 310.

Embodiments provide a phase change memory cell including resistance changing material at a minimum feature size below 46nm. The invention can also be applied to minimum feature sizes equal or greater 46nm. Embodiments provide memory elements with heater elements 355 which are formed including a line-lithography-process and cavities 321 filled with resistance changing material which are formed including a line-lithography process.

While the specific embodiments described herein substantially focused on fabricating phase change memory cells, the embodiments can be applied to any suitable type of resistive or resistivity changing memory cells.

Although specific embodiments have been illustrated and described herein, it will be appreciated by those of ordinary skill in the art that a variety of alternate and/or equivalent implementations may be substituted for the specific embodiments shown and described without departing from the scope of the present invention.

This application is intended to cover any adaptations or variations of the specific embodiments discussed herein. Therefore, it is intended that this invention be limited only by the claims and the equivalents thereof.

**Claims**

1. A method for fabricating an integrated circuit (100), the method comprising:

   forming a first electrode (350);
   forming a heater element (355) coupled to the first electrode (350);
   forming a cavity (321) over the heater element (355), the cavity (321) laterally surrounded by a first dielectric material (362) and a second dielectric material (364);
   depositing resistance changing material (320) into the cavity (321); and
   forming a second electrode (310) over the resistance changing material (310);
   wherein forming the heater element (355) comprises:

      depositing a third dielectric material (360) over the first electrode (350);
      structuring the third dielectric material (360) by means of a line-lithography-process; and
      depositing the heater material (355) over the third dielectric material (360);

   wherein forming the cavity (321) comprises:

      depositing a sacrificial material (365); and
      structuring the sacrificial material (365) by means of a line-lithography-process.

2. The method of claim 1, wherein forming the heater element (355) further comprising:

   structuring the heater material (355) in a first direction by a spacer-etch-process.

3. The method of claim 1 or claim 2, wherein forming the heater element (355) further comprising:

   depositing a forth dielectric material (370) over the heater material (355) after depositing the heater material (355) over the third dielectric material (360).

4. The method of one of the claims 1-3, wherein forming the cavity (321) further comprises:

   depositing a fifth dielectric material (380) over the sacrificial material (365);
   structuring the fifth dielectric material (380) by a spacer-etch-process;
   structuring the heater material (355) in a second direction by using the fifth dielectric material (380) as a mask; and
   forming the cavity (321) by removing the fifth dielectric material (380).

5. The method of one of the claims 1-4, further comprising:

   structuring the resistance changing material (320) by using damascene patterning in the cavity (321).

6. The method of one of the claims 1-5, wherein the resistance changing material (320) comprises phase change material.

7. The method of one of the claims 1-6, wherein depositing resistance changing material (320) into the cavity (321) comprises:

   depositing resistance changing material (320) by at least one of the group of physical vapor deposition (PVD)-process, chemical vapor deposition (CVD)-process, atomic layer deposition (ALD)-process, or solution based spin-on processes.

8. An integrated circuit (100) comprising:

   a first electrode (350);
   a heater element (355) coupled to the first electrode (350);
   a cavity (321) laterally surrounded by a first dielectric material (362) and a second dielectric material (364), the cavity (321) filled with resistance changing material (320) and coupled to the heater element (355); and
   a second electrode (310) coupled to the resistance changing material (310);
   and **characterized in that**
   the heater element (355) is L-shaped with a larger contact area towards the first electrode (350) compared to the contact area towards the cavity (321).

9. The integrated circuit (100) of claim 8, wherein the heater element (355) is a spacer formed by a spacer-etch-process.

10. The integrated circuit (100) of one of the claims 8-9, wherein the cavity (321) is formed by at least one spacer-etch-process.

11. The integrated circuit (100) of one of the claims 8-10, wherein the resistance changing material (320) comprises phase change material.

**12.** The integrated circuit (100) of one of the claims 8-11, wherein the resistance changing material (320) is deposited by at least one of the group of physical vapor deposition (PVD)-process, chemical vapor deposition (CVD)-process, atomic layer deposition (ALD)-process, or solution based spin-on processes.

**13.** The integrated circuit (100) of one of the claims 8-12, wherein one of the widths of the heater element (355) and one of the widths of the cavity (321) are the same.

**14.** A system (90) comprising:

> a host (92); and
> a memory device (100) communicatively coupled to the host (92), the memory device (100) comprising an integrated circuit of one of the claims 8-13.

**Patentansprüche**

**1.** Verfahren zum Herstellen einer integrierten Schaltung (100), wobei das Verfahren umfasst:

> Ausbilden einer ersten Elektrode (350);
> Ausbilden eines Heizelements (355), das mit der ersten Elektrode (350) gekoppelt ist;
> Ausbilden eines Hohlraums (321) über dem Heizelement (355), wobei der Hohlraum (321) seitlich von einem ersten dielektrischen Material (362) und von einem zweiten dielektrischen Material (364) umgeben ist;
> Ablagern eines Widerstandsänderungsmaterials (320) in dem Hohlraum (321); und
> Ausbilden einer zweiten Elektrode (310) über dem Widerstandsänderungsmaterial (320);
> wobei das Ausbilden des Heizelements (355) umfasst:
>
>> Ablagern eines dritten dielektrischen Materials (360) über der ersten Elektrode (350);
>> Strukturieren des dritten dielektrischen Materials (360) mittels eines Linienlithographieprozesses; und
>> Ablagern des Heizmaterials (355) über dem dritten dielektrischen Material (360);
>
> wobei das Ausbilden des Hohlraums (321) umfasst:
>
>> Ablagern eines Opfermaterials (365); und
>> Strukturieren des Opfermaterials (365) mittels eines Linienlithographieprozesses.

**2.** Verfahren nach Anspruch 1, bei dem das Ausbilden des Heizelements (355) ferner umfasst:

> Strukturieren des Heizmaterials (355) in einer ersten Richtung durch einen Abstandshalterätzprozess.

**3.** Verfahren nach Anspruch 1 oder Anspruch 2, bei dem das Ausbilden des Heizelements (355) ferner umfasst:

> Ablagern eines vierten dielektrischen Materials (370) über dem Heizmaterial (355) nach Ablagern des Heizmaterials (355) über dem dritten dielektrischen Material (360).

**4.** Verfahren nach einem der Ansprüche 1-3, bei dem das Ausbilden des Hohlraums (321) ferner umfasst:

> Ablagern eines fünften dielektrischen Materials (380) über dem Opfermaterial (365);
> Strukturieren des fünften dielektrischen Materials (380) durch einen Abstandshalterätzprozess;
> Strukturieren des Heizmaterials (355) in einer zweiten Richtung unter Verwendung des fünften dielektrischen Materials (380) als eine Maske; und
> Ausbilden des Hohlraums (321) durch Entfernen des fünften dielektrischen Materials (380).

**5.** Verfahren nach einem der Ansprüche 1-4, das ferner umfasst:

> Strukturieren des Widerstandsänderungsmaterials (320) unter Verwendung einer Damaszenermusterung in dem Hohlraum (321).

**6.** Verfahren nach einem der Ansprüche 1-5, bei dem das Widerstandsänderungsmaterial (320) ein Phasenänderungsmaterial umfasst.

**7.** Verfahren nach einem der Ansprüche 1-6, bei dem das Ablagern des Widerstandsänderungsmaterials (320) in dem Hohlraum (321) umfasst:

> Ablagern des Widerstandsänderungsmaterials (320) durch mindestens eines aus der Gruppe eines Gasphasenabscheidungsprozesses nach physikalischem Verfahren (PVD-Prozesses), eines Gasphasenabscheidungsprozesses nach chemischem Verfahren (CVD-Prozesses), eines Atomlagenablagerungsprozesses (ALD-Prozesses) oder lösungsbasierter Rotationsbeschichtungsprozesse.

**8.** Integrierte Schaltung (100), die umfasst:

> eine erste Elektrode (350);

ein Heizelement (355), das mit der ersten Elektrode (350) gekoppelt ist;

einen Hohlraum (321), der seitlich von einem ersten dielektrischen Material (362) und von einem zweiten dielektrischen Material (364) umgeben ist, wobei der Hohlraum (321) mit einem Widerstandsänderungsmaterial (320) gefüllt und mit dem Heizelement (355) gekoppelt ist; und

eine zweite Elektrode (310), die mit dem Widerstandsänderungsmaterial (320) gekoppelt ist; und **dadurch gekennzeichnet ist, dass**

das Heizelement (355) L-förmig mit einer größeren Kontaktfläche in Richtung der ersten Elektrode (350) im Vergleich zu der Kontaktfläche in Richtung des Hohlraums (321) ist.

9. Integrierte Schaltung (100) nach Anspruch 8, bei der das Heizelement (355) ein durch einen Abstandshalterätzprozess ausgebildeter Abstandshalter ist.

10. Integrierte Schaltung (100) nach einem der Ansprüche 8-9, bei dem der Hohlraum (321) durch mindestens einen Abstandshalterätzprozess ausgebildet worden ist.

11. Integrierte Schaltung (100) nach einem der Ansprüche 8-10, bei dem das Widerstandsänderungsmaterial (320) ein Phasenänderungsmaterial umfasst.

12. Integrierte Schaltung (100) nach einem der Ansprüche 8-11, bei dem das Widerstandsänderungsmaterial (320) durch mindestens eines aus der Gruppe eines Gasphasenabscheidungsprozesses nach physikalischem Verfahren (PVD-Prozesses), eines Gasphasenabscheidungsprozesses nach chemischem Verfahren (CVD-Prozesses), eines Atomlagenablagerungsprozesses (ALD-Prozesses) oder lösungsbasierter Rotationsbeschichtungsprozesse abgelagert worden ist.

13. Integrierte Schaltung (100) nach einem der Ansprüche 8-12, bei der eine der Breiten des Heizelements (355) und eine der Breiten des Hohlraums (321) dieselben sind.

14. System (90), das umfasst:

einen Host (92); und
eine Speichervorrichtung (100), die mit dem Host (92) kommunikationstechnisch gekoppelt ist, wobei die Speichervorrichtung (100) eine integrierte Schaltung nach einem der Ansprüche 8-13 umfasst.

## Revendications

1. Procédé de fabrication d'un circuit (100) intégré, procédé dans lequel :

on forme une première électrode (350) ;
on forme un élément (355) chauffant adjoint à la première électrode (350) ;
on forme une cavité (321) sur l'élément (355) chauffant, la cavité (321) étant entourée latéralement d'un premier matériau (362) diélectrique et d'un deuxième matériau (364) diélectrique ;
on dépose du matériau (320) changeant la résistance dans la cavité (321) ; et
on forme une deuxième électrode (310) sur le matériau (310) changeant la résistance ;
dans lequel former l'élément (355) chauffant comprend :

déposer un troisième élément (360) diélectrique sur la première électrode (350) ;
structurer le troisième matériau (360) diélectrique au moyen d'une opération de lithographie en ligne ; et
déposer le matériau (355) chauffant sur le troisième matériau (360) diélectrique ;
dans lequel former la cavité (321) comprend :

déposer un matériau (365) sacrificiel ; et
structurer le matériau (365) sacrificiel au moyen d'une opération de lithographie en ligne.

2. Procédé suivant la revendication 1, dans lequel former l'élément (355) chauffant comprend, en outre :

structurer le matériau (355) chauffant dans une première direction par une opération d'attaque à intercalaire.

3. Procédé suivant la revendication 1 ou revendication 2, dans lequel former l'élément (355) chauffant comprend, en outre :

déposer un quatrième matériau (370) diélectrique sur le matériau (355) chauffant, après avoir déposé le matériau (355) chauffant sur le troisième matériau (360) diélectrique.

4. Procédé suivant l'une des revendications 1 à 3, dans lequel former la cavité (321) comprend, en outre :

déposer un cinquième matériau (380) diélectrique sur le matériau (365) sacrificiel ;
structurer le cinquième matériau (380) diélectrique par un procédé d'attaque à intercalaire ;

structurer le matériau (355) chauffant dans une deuxième direction en utilisant le cinquième matériau (380) diélectrique comme masque ; et former la cavité (321) en enlevant le cinquième matériau (380) diélectrique.

5. Procédé suivant l'une des revendications 1 à 4, comprenant, en outre :

structurer le matériau (320) changeant la résistance en utilisant une structuration damascène dans la cavité (321).

6. Procédé suivant l'une des revendications 1 à 5, dans lequel le matériau (320) changeant la résistance comprend un matériau de changement de phase.

7. Procédé suivant l'une des revendications 1 à 6, dans lequel déposer du matériau (320) changeant la résistance dans la cavité (321) comprend :

déposer du matériau (320) changeant la résistance par au moins l'un du groupe d'une opération de dépôt physique en phase vapeur (PVD), d'une opération de dépôt chimique en phase vapeur (CVD), d'une opération de dépôt de couche atomique (ALD), ou d'opération de centrifugation à base de solution.

8. Circuit (100) intégré comprenant :

une première électrode (350) ;
un élément (355) chauffant adjoint à la première électrode (350) ;
une cavité (321) entourée latéralement d'un premier matériau (362) diélectrique et d'un deuxième matériau (364) diélectrique, la cavité (321) étant remplie de matériau (320) changeant la résistance et adjointe à l'élément (355) chauffant ; et
une troisième électrode (310) adjointe au matériau (310) changeant la résistance ;
et **caractérisé en ce que**
l'élément (355) chauffant est en forme de L en ayant une surface de contact tournée vers la première électrode (350) plus grande que la surface de contact tournée vers la cavité (321).

9. Circuit (100) intégré suivant la revendication 8, dans lequel l'élément (355) chauffant est un intercalaire formé par une opération d'attaque à intercalaire.

10. Circuit (100) intégré suivant l'une des revendications 8 à 9, dans lequel on forme la cavité par au moins une opération d'attaque à intercalaire.

11. Circuit (100) intégré suivant l'une des revendications 8 à 10, dans lequel le matériau (320) changeant la résistance comprend du matériau de changement de phase.

12. Circuit (100) intégré suivant l'une des revendications 8 à 11, dans lequel le matériau (320) changeant la résistance est déposé par au moins l'un du groupe d'une opération de dépôt physique en phase vapeur (PVD), d'une opération de dépôt chimique en phase vapeur (CVD), d'une opération de dépôt de couche atomique (ALD), ou d'opérations de centrifugation à base de solution.

13. Circuit (100) intégré suivant l'une des revendications 8 à 12, dans lequel l'une des largeurs de l'élément (355) chauffant et l'une des largeurs de la cavité (321) sont les mêmes.

14. Système (90) comprenant :

un hôte (92) ; et
un dispositif (100) de mémoire adjoint en communication à l'hôte (92), le dispositif (100) de mémoire comprenant un circuit intégré suivant l'une des revendications 8 à 13.

90

92

100

94

HOST

MEMORY
DEVICE

Fig. 1

**WRITE CIRCUIT** 102

110

112a

**MEMORY CELL** 106a

104

112b

**MEMORY CELL** 106b

120

112c

**MEMORY CELL** 106c

**DISTRIBUTION CIRCUIT**

**CONTROLLER**

112d

**MEMORY CELL** 106d

122

118

116

114

**SENSE CIRCUIT** 108

100

**Fig. 2**

300

310

| 364 | 320 | 364 |

| 361 | 355 | 360 |

340 350 340

**Fig. 3**

**Fig. 4a**

355

370

360

340    350    340    350    340

355

340    350    340    350    340

**Fig. 4b**

370  355          355
                    370

361          360          361

340    350    340    350    340

355

340    350    340    350    340

Fig. 4c

370   355                    355
                                   370        380

361              360              361

340      350      340      350      340

365              380

355

340      350      340      350      340

**Fig. 4d**

370  355                     355  370        380

361        355      360              355      361

340      350        340        350        340

380                    380

355

340      350        340        350        340

Fig. 4e

**Fig. 4f**

**Fig. 4g**

**Fig. 4h**

Fig. 4i

**Fig. 4j**

**Fig. 5a**

370  355          355  370      380

361            360            361

340    350    340    350    340

380          380

355

340    350    340    350    340

**Fig. 5b**

**Fig. 5c**

**Fig. 5d**

Fig. 5e

**Fig. 5f**

**Fig. 5g**

**Fig. 5h**

600

| forming a first electrode (350) | 610 |

↓

| forming a heater element (355) coupled to the first electrode (350) comprising a line-lithography-process | 620 |

↓

| forming a cavity (321) over the heater element (355) comprising a line-lithography-process | 630 |

↓

| depositing resistance changing material (320) into the cavity (321) | 640 |

↓

| forming a second electrode (310) over the resistance changing material (310) | 650 |

Fig. 6

**EP 2 276 083 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 200799405 B

### Non-patent literature cited in the description

- **AHN et al.** Highly Reliable 50nm Contact Cell Technology for 256Mb PRAM. *Symposium on VLSI Technology, Digest of Technical Papers,* 2005, 98-99
- **PELLIZZER et al.** Novel $\mu$Trench Phase-Change Memory Cell for Embedded and Stand-Alone Non-Volatile Memory Applications. *Symposium on VLSI Technology, Digest of Technical Papers,* 2004, 18-19

- **PIROVANO et al.** Self-Aligned $\mu$Trench Phase-Change Memory Cell Architecture for 90nm Technology and Beyond. *37th European Solid State Device Research Conference,* 2007, 222-225